# DEMANDE DE BREVET EUROPEEN

(11) **EP 3 181 007 A1**
(43) Date de publication de la demande: **21.06.2017**
(21) Numéro de dépôt: 15201257.1
(22) Date de dépôt: 18.12.2015
(51) Int. Cl.: A44C 27/00, G04B 37/22

(54) **ELEMENT D'HABILLAGE EN ZIRCONE A ZONES SELECTIVEMENT CONDUCTRICES POUR APPLICATIONS ELECTRONIQUES**

(71) Demandeur: The Swatch Group Research and Development Ltd., 2074 Marin (CH)
(72) Inventeur: CURCHOD, Loïc, 1004 Lausanne (CH); SPRINGER, Simon, 3007 Bern (CH)
(74) Mandataire: Goulette, Ludivine

(57) **Abrégé**

Élément d'habillage, pour objet portable, réalisé dans un premier matériau, le premier matériau étant un matériau céramique isolant, caractérisé en ce que la surface dudit élément d'habillage est au moins partiellement traitée de sorte à présenter au moins une transformation pourvue d'une conductivité électrique.

## Description

La présente invention concerne un élément d'habillage et son procédé de fabrication réalisé en céramique du type zircone dont la conductivité est modifiée sélectivement.

### ART ANTERIEUR

Il est connu des objets portables comme des montres ou des bracelets qui sont en partie réalisés en céramique. Une céramique connue est la zircone ZrO₂.

Par ailleurs, la tendance actuelle des objets portables est d'aller vers de plus en plus de fonctionnalités électroniques et de connectivité.

Cette augmentation de la technologie embarquée par les montres se présente sous la forme de l'intégration de moyens de commande tactiles offrant une utilisation plus intuitive et ludique ou se présente sous la forme de l'intégration de fonctions de communication sans fil, la montre pouvant alors communiquer avec un autre appareil comme un smartphone.

Toutefois, cette augmentation des fonctionnalités électroniques pose problème car elle implique une augmentation des composants et imposent des contraintes additionnelles sur les pièces d'habillage. Pour la communication, il est nécessaire d'avoir une antenne impliquant un support d'antenne et un connecteur pour relier l'antenne au module électronique principal. La zone où se trouve l'antenne doit être libre de pièces conductrices électriquement afin d'avoir les meilleures propriétés de transmission possibles.

De même, dans le cas de touches tactiles, il est nécessaire d'avoir des électrodes et donc d'avoir des moyens permettant de supporter ces électrodes et des moyens pour connecter ces électrodes au module électronique principal. Ces électrodes doivent aussi pouvoir être isolées électriquement d'éléments conducteurs perturbateurs.

On constate donc que l'intégration de nouvelles technologies a tendance à ajouter des composants et des contraintes, ce qui implique une miniaturisation et une adaptation de ceux-ci est donc une augmentation des coûts ou une augmentation de la taille du boitier de la montre ou un changement esthétique.

Il existe donc un besoin pour trouver une solution à cette augmentation des fonctionnalités électroniques dans une montre.

### RESUME DE L'INVENTION

La présente invention a pour but de pallier les inconvénients de l'art antérieur en proposant un élément d'habillage en céramique et son procédé de fabrication qui permettent la réalisation sélective de zones conductrices afin de permettre l'intégration de fonctionnalités.

A cet effet, l'invention concerne un élément d'habillage pour un objet portable réalisé dans un premier matériau, le premier matériau étant un matériau céramique isolant, caractérisé en ce que la surface dudit élément d'habillage est au moins partiellement traitée de sorte à présenter au moins une transformation pourvue d'une conductivité électrique non nulle.

Cette invention permet d'avoir un élément d'habillage qui présente des zones isolantes et des zones présentant une conductivité électrique telle qu'il est possible de les utiliser pour des applications de type pistes conductrices, antennes, circuits électroniques ou électrodes pour touches tactiles.

Dans un premier mode de réalisation, le premier matériau est de la zircone.

Dans un second mode de réalisation, la surface est sélectivement traitée pour être transformée en carbure de zirconium dont la conductivité est non-nulle.

Dans un troisième mode de réalisation, la surface est sélectivement traitée pour être transformée en nitrure de zirconium dont la conductivité est non-nulle.

Dans un quatrième mode de réalisation, la surface comprend au moins une creusure, la surface étant traitée pour être transformée en carbure ou nitrure, puis polie pour localiser cette transformation au niveau de ladite creusure.

Dans un cinquième mode de réalisation, la surface comprend au moins une partie saillante, la surface étant traitée pour être transformée en carbure ou nitrure, puis polie pour exclure cette transformation de ladite partie saillante.

Dans un sixième mode de réalisation, la surface est transformée en carbure ou nitrure de manière homogène, puis usinée localement pour localiser la transformation sur les parties non-usinées.

La présente invention concerne aussi un objet portable comprenant l'élément d'habillage selon l'une des revendications précédentes.

Dans un premier mode de réalisation, ledit objet portable est une pièce d'horlogerie comprenant un boitier formé par une carrure, munie d'une lunette, fermée par un fond et une glace, ledit objet portable comprenant en outre des moyens de commande, et un bracelet avec son fermoir fixé à la carrure via deux paires de cornes, et en ce que l'élément d'habillage est choisi pour être agencé dans la liste comprenant la carrure, la lunette, les moyens de commande, le fond, le bracelet ou le fermoir.

Dans un autre mode de réalisation, ledit objet portable comprend en outre un module électronique apte à utiliser ladite surface traitée de sorte à présenter au moins une transformation pourvue d'une conductivité électrique non nulle pour opérer au moins une fonction.

Dans un autre mode de réalisation, la surface traitée de sorte à présenter au moins une transformation pourvue d'une conductivité électrique non nulle sera une antenne pour opérer une fonction de communication.

Dans un autre mode de réalisation, la surface traitée de sorte à présenter au moins une transformation pourvue d'une conductivité électrique non nulle sera une électrode pour opérer une fonction de commande.

Dans un autre mode de réalisation, la surface traitée de sorte à présenter au moins une transformation pourvue d'une conductivité électrique non nulle sera une paroi utilisée dans une fonction blindage permettant d'isoler un module ou composant électronique des perturbations d'un autre module ou composant électronique.

Dans un autre mode de réalisation, la surface traitée de sorte à présenter au moins une transformation pourvue d'une conductivité électrique non nulle sera au moins une pistes conductrices permettant de relier électriquement un module ou composant électronique à au moins un autre module ou composant électronique.

La présente invention concerne en outre un procédé de traitement d'un élément d'habillage pour un objet portable réalisé dans un premier matériau, le premier matériau étant un matériau céramique isolant, ledit procédé comprenant les étapes suivantes :
- Se munir de l'élément d'habillage et le placer dans une enceinte fermée hermétiquement et contenant une atmosphère chargée atomiquement d'un élément chimique ;
- Chauffer localement, par l'intermédiaire d'une première source de chaleur focalisée comme par exemple un laser, la surface de l'élément d'habillage de sorte que les atomes de l'atmosphère de l'enceinte se combinent localement avec la surface du premier matériau à l'endroit où ladite surface est chauffée.

Dans un premier mode de réalisation, l'atmosphère est créée par dissociation d'un gaz via la même source de chaleur chauffant localement la surface de l'élément d'habillage.

Dans un deuxième mode de réalisation, l'atmosphère est créée par dissociation d'un gaz via une seconde source de chaleur indépendante de celle qui chauffe localement la surface de l'élément d'habillage.

Dans un troisième mode de réalisation, l'atmosphère est créée par dissociation d'un gaz via une deuxième source de chaleur indépendante de la première source qui chauffe localement la surface de l'élément d'habillage, l'élément d'habillage étant chauffé de manière homogène via une troisième source de chaleur à une température plus faible que celle permettant la combinaison des atomes de l'atmosphère avec le premier matériau, la première source de chaleur servant à élever localement la température de la surface de l'élément d'habillage afin de permettre la combinaison des atomes de l'atmosphère avec le premier matériau.

Dans une première variante, ledit procédé comprend les étapes suivantes :
- Se munir de l'élément d'habillage ;
- Déposer localement sur la surface dudit élément d'habillage une couche métallique qui agira comme un masque pour limiter la carburation ou la nitruration de la zircone aux zones de la surface de l'élément d'habillage non-protégées par le dépôt métallique ;
- Placer ledit élément d'habillage dans une enceinte fermée hermétiquement et contenant une atmosphère chargée atomiquement d'un élément chimique et chauffer la surface de l'élément d'habillage de sorte que les atomes du composé de l'atmosphère de l'enceinte se combinent avec la surface du premier matériau non recouverte du dépôt métallique ;
- Attaquer sélectivement et chimiquement la surface dudit élément d'habillage afin de retirer le dépôt métallique afin de confiner les zones conductrices aux zones non-couvertes par le dépôt métallique lors de l'étape de carburation/nitruration.

Dans un premier mode de réalisation, le dépôt métallique sélectif est réalisé par dépôt au travers d'un masque préalablement posé sur l'élément d'habillage.

Dans un second mode de réalisation, le dépôt métallique sélectif est réalisé par dépôt suivi d'une étape de structuration par laser de la surface dudit élément d'habillage.

Dans un troisième mode de réalisation, le dépôt métallique sélectif est réalisé par dépôt suivi d'une étape de photolithographie de la surface dudit élément d'habillage.

Dans un quatrième mode de réalisation, l'étape consistant à déposer une couche métallique sélective consiste à déposer une couche d'épargne sur la totalité de la surface dudit élément d'habillage puis à graver sélectivement cette couche d'épargne selon une forme désirée puis à déposer la coche métallique sur la totalité de la surface dudit élément d'habillage, la couche d'épargne restant étant ensuite enlevée par attaque chimique.

Dans une seconde variante, ledit procédé comprend les étapes suivantes :
- Se munir de l'élément d'habillage ;
- Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface du premier matériau ;
caractérisé en ce que ledit procédé comprend en outre, préalablement ou postérieurement à l'étape consistant à traiter ledit élément d'habillage, une étape de structuration de l'élément d'habillage permettant la création de relief sur sa surface.

Dans un premier mode de réalisation, lorsque l'étape de structuration de l'élément d'habillage est réalisée postérieurement à l'étape consistant à traiter la surface dudit élément d'habillage, la structuration ôte la couche superficielle sur les zones structurées et la localise sur les zones non-structurées.

Dans un second mode de réalisation, le procédé comprend en outre, lorsque l'étape de structuration de l'élément d'habillage est réalisée antérieurement à l'étape consistant à traiter la surface dudit élément d'habillage, une étape de polissage pour enlever la couche superficielle sur la partie haute de la surface en relief de l'élément d'habillage et localiser ainsi les zones conductrices aux creusures non-touchées par le polissage.

### BREVE DESCRIPTION DES FIGURES

Les buts, avantages et caractéristiques de l'invention apparaîtront plus clairement dans la description détaillée suivante d'au moins une forme de réalisation de l'invention donnée uniquement à titre d'exemple non limitatif et illustrée par les dessins annexés sur lesquels :
- Les figures 1 et 2 représentent schématiquement l'objet portable selon l'invention;
- Les figures 3 à 5 représentent schématiquement un premier mode de réalisation du procédé selon l'invention;
- Les figures 6 à 20 représentent schématiquement un second mode de réalisation du procédé selon l'invention;
- Les figures 21 et 22 représentent schématiquement un troisième mode de réalisation du procédé selon l'invention;

### DESCRIPTION DETAILLEE

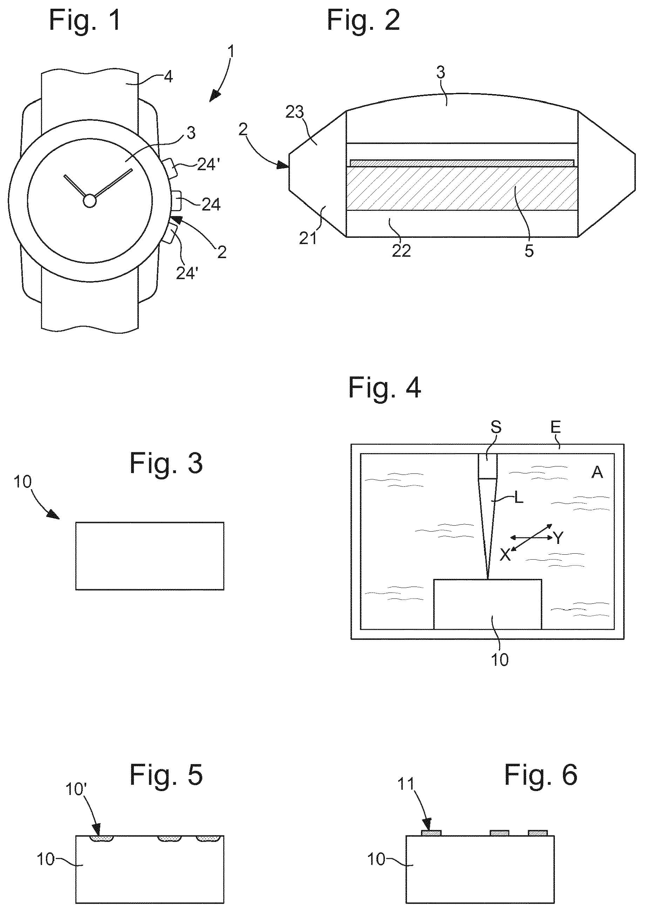

Sur les figures 1 et 2, un objet portable 1 selon l'invention est décrit. Un exemple d'objet portable selon l'invention est une pièce d'horlogerie. Une telle pièce d'horlogerie comprend un boitier 2 formé par une carrure 21 fermée par un fond 22 et une glace 3. Ce boitier 2 renferme un module électronique pouvant être un mouvement horloger 5 électronique ou électromécanique. Ce module électronique peut être associé à un autre élément comme un mouvement mécanique. Cette objet portable peut également comprendre un bracelet 4 comprenant deux brins 4' ou une pluralité de maillons. Un élément d'habillage selon l'invention est donc compris dans la liste comprenant la carrure, la lunette, le fond, le bracelet, le fermoir, la boucle déployante ou la boucle - ardillon nécessaire à la fermeture du bracelet. Bien entendu, la montre peut également comprendre une lunette 23, tournante ou non, intégrée ou non à la carrure, ainsi que des moyens de commande comme une tête de couronne 24 ou des boutons-poussoirs 24'. La carrure 21 pourra être munie d'une lunette intégrée ou rapportée.

L'élément d'habillage selon l'invention est réalisé dans un premier matériau. Ce matériau est choisi pour être du type céramique. La céramique utilisée ici est de l'oxyde de zirconium ZrO₂ également appelé zircone.

Avantageusement selon l'invention, cet élément d'habillage 10 en céramique est traité en surface. Ce traitement en surface est opéré de sorte à être sélectif c'est-à-dire que l'élément d'habillage 10 n'est pas obligatoirement traité sur l'intégralité de sa surface. Ce traitement de surface est utilisé afin d'obtenir un changement de conductivité électrique sur des zones spécifiques.

Dans un premier mode de réalisation visible aux figures 3 à 5, le traitement selon la présente invention consiste en une carburation/nitruration sélective de l'élément d'habillage 10 par une source de chaleur focalisée, comme un laser. Pour rappel, une carburation/nitruration consiste à activer la pièce à carburer/nitrurer en la chauffant dans une atmosphère chargée en atomes de carbone ou d'azote.

La première étape consiste donc à se munir de l'élément d'habillage 10 qui sera traitée et à le placer dans une enceinte E. Cette enceinte E est fermée hermétiquement et contient une atmosphère A chargée en atomes de carbone C ou d'azote N suivant que l'on pratique une carburation ou nitruration. Cette atmosphère A chargée en atomes de carbone C ou d'azote N peut être créée par dissociation de composés tel que le méthane CH₄, le diazote N₂ ou l'ammoniac NH₃- Cette dissociation est opérer en chauffant les composés de base pour briser les liaisons moléculaires et obtenir des atmosphères atomiques.

La seconde étape consiste à carburer ou nitrurer sélectivement l'élément d'habillage 10 en activant par chauffage la surface de la pièce dans des zones choisies 10'. Pour pouvoir chauffer sélectivement ladite surface dans les zones choisies 10', une source de chaleur focalisée S, e.g. un laser fournissant un faisceau laser L, est utilisée. Ce faisceau laser est préférentiellement pulsé. La surface de l'élément d'habillage 10 est alors chauffée localement dans les zones 10' à une température comprise entre 700 et 1100°C pendant une durée de 30 à 180 minutes. Sous l'effet de cette température les atomes de carbone ou d'azote de l'atmosphère A de l'enceinte E se combinent avec la surface en zircone dans les zones 10' de l'élément d'habillage 10. Il s'agit d'une transformation de la surface des zones 10' de l'élément d'habillage 10 sur une faible épaisseur, de l'ordre de 10 à 500 nm, en carbure de zirconium ou nitrure de zirconium ayant un aspect métallique de couleur platine ou proche de l'or jaune respectivement, et une conductivité non-nulle. Il s'agit donc d'une modification superficielle de la structure de la zircone en une nouvelle structure cristallographique correspondant à celle du carbure de zirconium/nitrure de zirconium et non d'un revêtement rapporté susceptible d'être arraché ou de se désolidariser de la surface de l'article, notamment lorsque celui-ci est soumis à des conditions d'usure importante. Plus particulièrement, la couche superficielle qui présente la structure du carbure de zirconium ou du nitrure de zirconium s'étend à partir de la surface sur une profondeur comprise entre 10 et 500 nm.

Or, le carbure de zirconium et le nitrure de zirconium présentent une conductivité électrique non nulle au contraire de la zircone qui est considérée comme un matériau isolant. De ce fait, les zones qui sont carburées ou nitrurées présentent une conductivité électrique non nulle. Comme le reste de l'élément d'habillage n'est pas transformé, on se retrouve avec des zones conductrices entourées de zones isolantes.

Pour opérer les différentes étapes, il peut être prévu plusieurs modes d'exécution.

Dans un premier mode d'exécution, la dissociation des gaz pour obtenir une atmosphère chargée en atomes de carbone C ou d'azote N et l'activation locale de la surface dudit élément d'habillage utilisent le même laser.

Dans un second mode d'exécution, la dissociation des gaz pour obtenir une atmosphère chargée en atomes de carbone C ou d'azote N est opérée par une première source de chaleur alors que l'activation locale de la surface dudit élément d'habillage 10 utilise le laser.

Dans un troisième mode d'exécution, la dissociation des gaz pour obtenir une atmosphère chargée en atomes de carbone C ou d'azote N est opérée par une première source de chaleur, l'élément d'habillage 10 est chauffé via une seconde source de chaleur alors que l'activation locale de la surface de l'élément d'habillage utilise le laser. Ce troisième mode d'exécution permet de préchauffer l'élément d'habillage 10 de manière homogène et d'avoir un écart de température moins élevé dans la zone de la surface de l'élément d'habillage 10 traitée par la source de chaleur focalisée.

Un avantage de ce premier mode de réalisation est qu'il permet aisément une activation sélective de la surface de l'élément d'habillage 10. En effet, un faisceau laser présente l'avantage d'avoir un diamètre de faisceau réglable.

Dans un second mode de réalisation visible aux figures 6 à 20, le principe utilise une métallisation sélective comme masque pour obtenir une carburation ou nitruration sélective de la surface de l'élément d'habillage 10.

La première étape consiste donc à se munir de l'élément d'habillage 10 et de lui apposer une métallisation 11 sur sa surface. Cette métallisation est sélective c'est-à-dire qu'elle est effectuée sur la ou les zones que l'on désire carburer ou nitrurer. Ce dépôt métallique est réalisé par exemple dans un matériau compris dans la liste incluant le Chrome, le Tantale, le Molybdène, le Tungstène, le Niobium, le Titane, le Silicium et est réalisé selon plusieurs modes d'exécution.

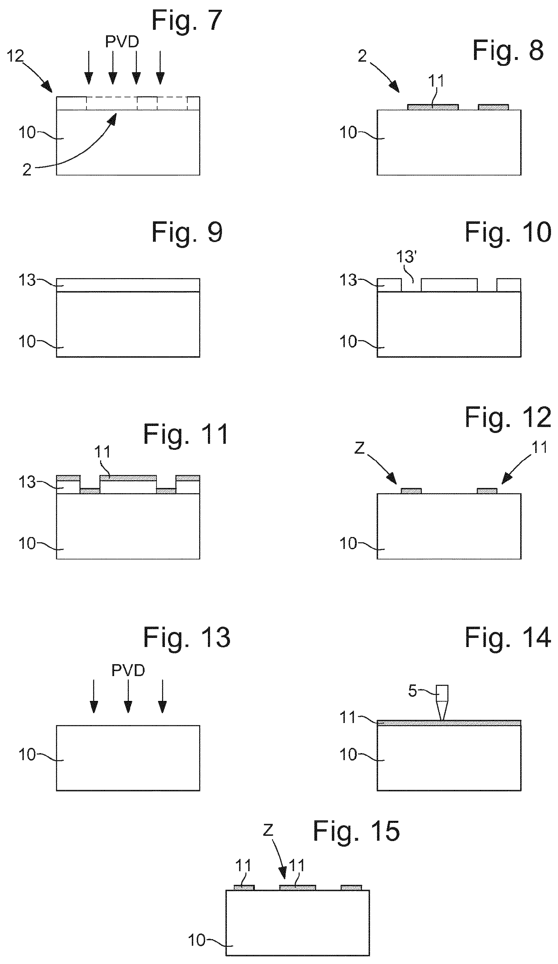

Dans un premier mode d'exécution visible aux figures 7 et 8, la métallisation est réalisée par masquage de la surface de l'élément d'habillage 10 via un masque 12 suivi par une déposition métallique via un procédé du type dépôt physique en phase vapeur PVD. Ainsi, seules les zones Z non recouvertes par le masque reçoivent le dépôt de métal 11.

Dans un second mode d'exécution visible aux figures 9 à 12, la métallisation est réalisée en déposant une couche d'épargne 13 comme une couche de capton ou une couche d'encre ou de laque ou de résine sur la surface de l'élément d'habillage. Cette couche 13 est alors sélectivement gravée selon l'esthétisme voulu et laisse apparaitre des ouvertures 13'. Le tout est alors recouvert d'une couche métallique 11 par dépôt PVD, la couche se déposant tant sur la couche d'épargne 13 que dans les creusures faites dans ladite épargne. Enfin la couche d'épargne 13 est enlevée par attaque chimique laissant la couche métallique 11 uniquement sur les zones Z correspondant aux endroits des creusures 13' de l'épargne retirée.

Dans un troisième mode d'exécution visible aux figures 13 à 15, le dépôt métallique sélectif consiste à déposer sur métal 11 sur la totalité de la surface de l'élément d'habillage 10 pour ensuite utiliser une source de chaleur focalisée S tel un laser pour structurer la couche métallique 11 déposée. Cette structuration consiste en un décapage de la surface de l'élément d'habillage 10 pour enlever la couche métallique 11 aux endroits non désirés et laissant la couche métallique 11 sur les zones désirées Z.

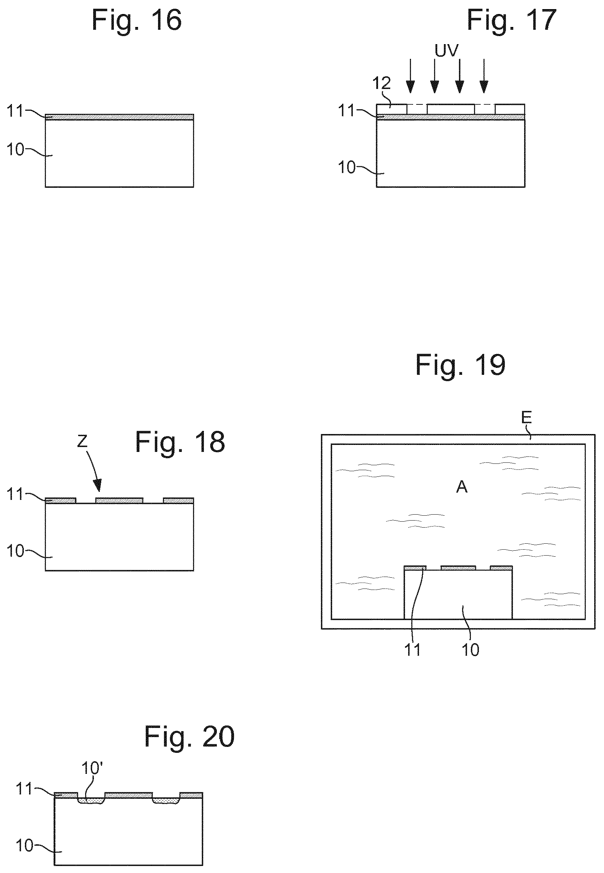

Dans un quatrième mode d'exécution visible aux figures 16 à 18, le dépôt métallique sélectif consiste à déposer le métal sur la totalité de la surface de l'élément d'habillage 10. Suite à cela, une étape de photolithographie est utilisée avec un masque 12 pour modifier localement la couche métallique 11 déposée. Cette modification locale est suivie d'une étape d'attaque chimique pour enlever la couche métallique 11 aux endroits non désirés et la laisser sur les zones désirées Z.

Une fois ce dépôt métallique réalisé, l'étape suivante consiste à carburer ou nitrurer l'élément d'habillage 10 avec la couche métallique 11 sur les zones Z de sa surface. Pour cela, l'élément d'habillage 10 est placé dans une enceinte E qui contient une atmosphère A chargée en atomes de carbone C ou d'azote N, comme indiqué à la figure 19. Le tout est alors chauffé en utilisant une technique plasma telle que décrite dans le brevet EP 0 850 900. Or, le dépôt métallique 11 fait ici office de bouclier empêchant la carburation/nitruration des zones recouvertes par ce dépôt métallique 11 et permettant la transformation aux zones 10' non recouvertes comme visible à la figure 20.

Dans une étape suivante, le dépôt métallique 11 est chimiquement dissout pour laisser apparaitre la zircone dans sa couleur d'origine. On obtient donc un élément d'habillage ayant une zone mise à nue et une zone carburée/nitrurée et donc conductrice.

Dans un troisième mode de réalisation, la transformation sélective de de la surface de l'élément d'habillage en zone conductrice utilise le principe de carburation/nitruration et structuration.

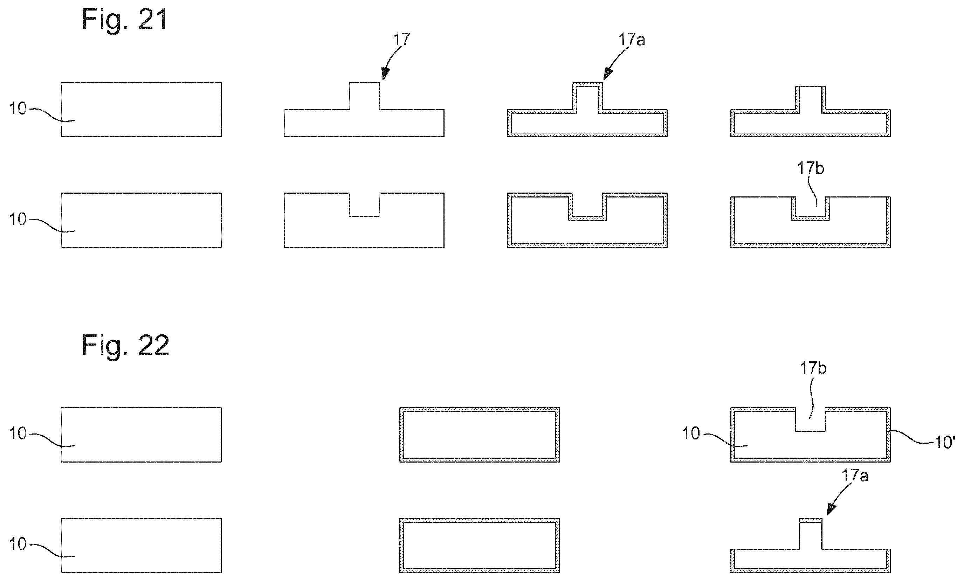

Dans un premier mode d'exécution visible à la figure 21, la première étape consiste à se munir de l'élément d'habillage 10 en zircone. Cette première étape consiste également à structurer cet élément d'habillage 10. Cette structuration peut être opérer de deux manières différentes : Durant la fabrication de l'élément d'habillage 10 ou postérieure à cette fabrication.

Dans le cas où la structuration est réalisée pendant la fabrication de l'élément d'habillage, on comprendra que cette fabrication consiste à mélanger entre elles des poudres pour ensuite les mettre dans un moule et les fritter c'est à dire les soumettre à une température et une pression telle qu'une transformation s'opère. Ainsi, le moule dans lequel les poudres sont placées peut avoir une forme incluant les reliefs, structurations désirés.

Dans le cas où la structuration est réalisée postérieurement à la fabrication de l'élément d'habillage, un usinage mécanique ou laser est envisageable.

Dans une seconde étape, l'élément d'habillage est carburé ou nitruré. Pour cela, l'élément d'habillage 10 structuré est placé dans une enceinte E dans laquelle se trouve une atmosphère A chargée en atomes de carbone ou d'azote. Le tout est alors chauffé via un plasma durant une durée déterminée afin de transformer la surface de l'élément d'habillage 10 en carbure ou nitrure de zirconium conducteur respectivement. Cette carburation/nitruration est donc réalisée sur la totalité de la surface de l'élément d'habillage.

Dans une troisième étape, l'élément d'habillage subit une étape de polissage. Cette étape de polissage consiste à enlever la couche superficielle de l'élément d'habillage 10. Or, l'élément d'habillage 10 est munie de structurations 17 se présentant sous la forme de creux 17b ou de parties saillantes 17a, ces creux 17b ou parties saillantes 17a étant eux aussi carburés/nitrurés. Par conséquent, le polissage ne concerne pas l'intégralité de la surface de l'élément d'habillage 10. Effectivement, dans le cas où les structurations 17 sont des creusures, l'opération de polissage laisse la carburation/nitruration, c'est-à-dire les parties conductrices, dans les creusures. Dans le cas où les structurations 17 sont des parties saillantes, l'opération de polissage enlève la carburation/nitruration au niveau de ces parties saillantes.

Ainsi, on obtient un relief dont les creusures sont sélectivement conductrices.

Dans un second mode d'exécution visible à la figure 22, la première étape consiste à se munir de l'élément d'habillage en zircone.

Dans une seconde étape, ledit élément d'habillage est carburé/nitruré. Pour cela, l'élément d'habillage 10 structuré est placé dans une enceinte dans laquelle se trouve une atmosphère chargée en atomes de carbone ou d'azote. Le tout est alors chauffé via un plasma durant une durée déterminée afin de transformer la surface de l'élément d'habillage en carbure ou nitrure de zirconium conducteur respectivement. Cette carburation/nitruration est donc réalisée sur la totalité de la surface de l'élément d'habillage.

Dans une troisième étape, l'élément d'habillage 10 subit une étape de structuration. Cette étape consiste à enlever de la matière de l'élément d'habillage. Pour cela, un usinage mécanique ou laser est utilisé. L'enlèvement de matière peut être opéré de sorte à n'enlever localement que la couche superficielle de 10 à 500 nm qui est transformée en carbure ou nitrure. Toutefois, l'enlèvement de matière peut être opéré de sorte à accentuer le relief au niveau des zones conductrices.

Cette transformation de l'élément d'habillage en surface pour présenter des zones ayant une conductivité électrique permet de réaliser des pistes conductrices pour relier électriquement un module ou composant électronique à au moins un autre module ou composant électronique, des antennes intégrées, ainsi que des électrodes pour des touches ou commandes tactiles. Ces zones ayant une conductivité électrique non nulle seront utilisées par le module électronique de l'objet portable. Ces zones ayant une conductivité électrique non nulle permettent également d'opérer une fonction blindage c'est-à-dire permettant d'isoler un module ou composant électronique des perturbations d'un autre module ou composant électronique.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention défini par les revendications annexées.

Ainsi, on comprendra que l'élément d'habillage peut être traitée à différents endroits sur sa surface.

## Revendications

1. Elément d'habillage (10) pour objet portable réalisé dans un premier matériau, le premier matériau étant un matériau céramique isolant, **caractérisé en ce que** la surface dudit élément d'habillage est au moins partiellement traitée de sorte à présenter au moins une transformation pourvue d'une conductivité électrique non nulle.

2. Elément d'habillage selon la revendication 2, **caractérisé en ce que** le premier matériau est de la zircone.

3. Elément d'habillage selon les revendications 1 ou 2, **caractérisé en ce que** la surface est sélectivement traitée pour être transformée en carbure.

4. Elément d'habillage selon les revendications 1 ou 2, **caractérisé en ce que** la surface est sélectivement traitée pour être transformée en nitrure.

5. Elément d'habillage selon l'une des revendications 1 à 4, **caractérisé en ce que** la surface comprend au moins une creusure (17b), la surface étant traitée pour être transformée en carbure ou nitrure et polie pour localiser cette transformation au niveau de ladite creusure.

6. Elément d'habillage selon l'une des revendications 1 à 4, **caractérisé en ce que** la surface comprend au moins une partie saillante (17a), la surface étant traitée pour être transformée en carbure ou nitrure et polie pour exclure cette transformation de ladite partie saillante.

7. Objet portable comprenant l'élément d'habillage selon l'une des revendications précédentes.

8. Objet portable selon la revendication 7, **caractérisé en ce que** ledit objet portable est une pièce d'horlogerie comprenant un boitier (2) formé par une carrure (21), munie d'une lunette, fermée par un fond (22) et une glace (3), ledit objet portable comprenant en outre des moyens de commande (24, 24'), et un bracelet (4) fixé à la carrure via deux paires de cornes, et **en ce que** l'élément d'habillage est choisi pour être agencé dans la liste comprenant la carrure, la lunette, les moyens de commande, le fond, le bracelet ou le fermoir.

9. Objet portable selon la revendication 8, **caractérisé en ce que** ledit objet portable comprend en outre un module électronique (5) apte à utiliser ladite surface traitée de sorte à présenter au moins une transformation pourvue d'une conductivité électrique non nulle pour opérer au moins une fonction.

10. Objet portable selon la revendication 9, **caractérisé en ce que** la surface traitée de sorte à présenter au moins une transformation pourvue d'une conductivité électrique non nulle sera une antenne pour opérer une fonction de communication.

11. Objet portable selon les revendications 9 ou 10, **caractérisé en ce que** la surface traitée de sorte à présenter au moins une transformation pourvue d'une conductivité électrique non nulle sera une électrode pour opérer une fonction de commande.

12. Objet portable selon l'une des revendications 9 à 11, **caractérisé en ce que** la surface traitée de sorte à présenter au moins une transformation pourvue d'une conductivité électrique non nulle sera une paroi utilisée dans une fonction blindage permettant d'isoler un module ou composant électronique des perturbations d'un autre module ou composant électronique.

13. Objet portable selon l'une des revendications 9 à 12, **caractérisé en ce que** la surface traitée de sorte à présenter au moins une transformation pourvue d'une conductivité électrique non nulle sera au moins une pistes conductrices permettant de relier électriquement un module ou composant électronique à au moins un autre module ou composant électronique.

14. Procédé de traitement d'un élément d'habillage (10) pour objet portable réalisé dans un premier matériau, le premier matériau étant un matériau céramique isolant, ledit procédé comprenant les étapes suivantes :
• Se munir de l'élément d'habillage et le placer dans une enceinte (E) fermée hermétiquement et contenant une atmosphère chargée atomiquement d'un élément chimique ;
• Chauffer localement, par l'intermédiaire d'une première source de chaleur (S) focalisée, la surface de l'élément d'habillage de sorte que les atomes de l'atmosphère de l'enceinte se combinent avec la surface du premier matériau.

15. Procédé de traitement selon la revendication 14, **caractérisé en ce que** l'atmosphère est créée par dissociation d'un gaz via une seconde source de chaleur.

16. Procédé de traitement selon la revendication 14, **caractérisé en ce que** l'atmosphère est créée par dissociation d'un gaz via une seconde source de chaleur, l'élément d'habillage étant chauffé à une température plus faible que la température d'activation de la combinaison des atomes de l'atmosphère avec la surface du premier matériau via une troisième source de chaleur.

17. Procédé de traitement d'un élément d'habillage (10) pour objet portable réalisé dans un premier matériau, le premier matériau étant un matériau céramique isolant, ledit procédé comprenant les étapes suivantes :
• Se munir de l'élément d'habillage ;
• Déposer localement sur la surface dudit élément d'habillage une couche métallique (11);
• Placer ledit élément d'habillage dans une enceinte fermée hermétiquement et contenant une atmosphère chargée atomiquement d'un élément chimique et chauffer la surface de l'élément d'habillage de sorte que les atomes de l'atmosphère de l'enceinte se combinent avec la surface du premier matériau non recouverte du dépôt métallique.
• Attaquer sélectivement et chimiquement la surface dudit élément d'habillage afin de retirer le dépôt métallique.

18. Procédé de traitement selon la revendication 17, **caractérisé en ce que** le dépôt métallique sélectif est réalisée par dépôt au travers d'un masque (12) préalablement posé sur l'élément d'habillage.

19. Procédé de traitement selon la revendication 17, **caractérisé en ce que** le dépôt métallique sélectif est réalisée par dépôt suivi d'une étape de structuration par laser de la surface dudit élément d'habillage.

20. Procédé de traitement selon la revendication 17, **caractérisé en ce que** le dépôt métallique sélectif est réalisée par dépôt suivi d'une étape de photolithographie de la surface dudit élément d'habillage.

21. Procédé de traitement selon la revendication 17, **caractérisé en ce que** l'étape consistant à déposer une couche métallique (11) consiste à déposer une couche d'épargne (13) sur la totalité de la surface dudit élément d'habillage puis à graver sélectivement cette couche d'épargne selon une forme désirée puis à déposer la couche métallique (11) sur la totalité de la surface dudit élément d'habillage, la couche d'épargne restante étant ensuite enlevée par attaque chimique, laissant ainsi la couche métallique aux endroits où la couche d'épargne était préalablement gravée.

22. Procédé de traitement d'un élément d'habillage (10) pour objet portable réalisé dans un premier matériau, le premier matériau étant un matériau céramique isolant, ledit procédé comprenant les étapes suivantes :
• Se munir de l'élément d'habillage ;
• Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface du premier matériau ;
**caractérisé en ce que** ledit procédé comprend en outre, préalablement ou postérieurement à l'étape consistant à traiter ledit élément d'habillage, une étape de structuration de l'élément d'habillage permettant la création de relief (17) sur sa surface et de localiser la couche carburée/nitrurée conductrice dans les parties saillantes ou les creusures du relief.

23. Procédé de traitement selon la revendication 22, **caractérisé en ce qu'**il comprend en outre, lorsque l'étape de structuration de l'élément d'habillage est réalisée antérieurement à l'étape consistant à traiter ledit élément d'habillage, une étape de polissage pour enlever la couche superficielle carburée/nitrurée sur les parties saillantes de la surface en relief de l'élément d'habillage.
